# EUROPEAN PATENT APPLICATION

(11) **EP 4 750 008 A1**
(43) Date of publication of application: **27.05.2026**
(21) Application number: 25217207.7
(22) Date of filing: 20.11.2025
(51) Int. Cl.: H04L 25/02, H04L 25/03, H04L 25/49

(54) **SYSTEM AND METHOD FOR DISTORTION MITIGATION**

(30) Priority: 25.11.2024 US 202463724880 P; 20.06.2025 US 202519245252
(71) Applicant: Samsung Electronics Co., Ltd., Suwon-si, Gyeonggi-do 16677 (KR)
(72) Inventor: PARK, Joung Won, San Jose, CA, 95134 (US); KIM, Jaehyup, San Jose, CA, 95134 (US); KANG, Dae Hyun, San Jose, CA, 95134 (US)
(74) Representative: Kuhnen & Wacker Patent- und Rechtsanwaltsbüro PartG mbB

(57) **Abstract**

A system and method for distortion mitigation. In some embodiments, a system, includes: a transmitter, including: a pulse amplitude modulation driver circuit. The pulse amplitude modulation driver circuit may include a main driver including a most significant bit, MSB, amplifier (305), and a least significant bit, LSB, amplifier (310). The LSB amplifier (310) may include an upper arm and a lower arm, a strength of the upper arm or a strength of the lower arm being adjustable.

## Description

### FIELD

One or more aspects of embodiments according to the present disclosure relate to data links, and more particularly to a system and method for distortion mitigation in a data link.

### BACKGROUND

Data links may be used in various applications, such as between separately packaged devices, or between dies of a multi-chip module.

It is with respect to this general technical environment that aspects of the present disclosure are related.

The above information disclosed in this Background section is only for enhancement of understanding of the background and therefore the information discussed in this Background section does not necessarily constitute prior art.

### SUMMARY

According to an embodiment of the present disclosure, there is provided a system, including: a transmitter, including: a pulse amplitude modulation driver circuit, including: a main driver including a most significant bit (MSB) amplifier and a least significant bit (LSB) amplifier, the LSB amplifier including an upper arm and a lower arm, a strength of the upper arm or a strength of the lower arm being adjustable.

In some embodiments, the strength of the upper arm is adjustable, and the upper arm includes: a switching transistor; and a strength-adjusting transistor, connected in series with the switching transistor.

In some embodiments: the strength of the lower arm is adjustable independently of the strength of the upper arm, and the lower arm includes: a switching transistor and a strength-adjusting transistor, connected in series with the switching transistor of the lower arm.

In some embodiments, the system further includes a feedforward equalizer (FFE) driver including an MSB amplifier and an LSB amplifier.

In some embodiments: the LSB amplifier of the FFE driver includes an upper arm and a lower arm, and a strength of the upper arm and a strength of the lower arm of the LSB amplifier of the FFE driver are independently adjustable.

In some embodiments: the MSB amplifier includes an upper arm and a lower arm, and the strength of the upper arm of the MSB amplifier or the strength of the lower arm of the MSB amplifier is adjustable.

In some embodiments, the transmitter is configured: to receive an indication from a receiver connected to the transmitter, and to adjust the strength of the upper arm or the strength of the lower arm based on the indication.

In some embodiments, the indication is an instruction to adjust the strength of the upper arm or the strength of the lower arm.

In some embodiments, the indication is an indication of an eye size.

In some embodiments, the system further includes the receiver, wherein the receiver is configured to generate the indication based on a measure of distortion of a pulse amplitude modulation signal received from the transmitter.

In some embodiments, the measure of distortion is a Shmoo array.

According to an embodiment of the present disclosure, there is provided a method, including: receiving, by a transmitter, from a receiver connected to the transmitter, an indication; and based on the indication, adjusting, by the transmitter, a predistortion characteristic of a pulse amplitude modulation driver circuit of the transmitter.

In some embodiments: the pulse amplitude modulation driver circuit includes a main driver including a most significant bit (MSB) amplifier and a least significant bit (LSB) amplifier; and the LSB amplifier includes an upper arm and a lower arm, a strength of the upper arm or a strength of the lower arm being adjustable.

In some embodiments, the strength of the upper arm is adjustable, and the upper arm includes: a switching transistor; and a strength-adjusting transistor, connected in series with the switching transistor.

In some embodiments: the strength of the lower arm is adjustable independently of the strength of the upper arm, and the lower arm includes: a switching transistor and a strength-adjusting transistor, connected in series with the switching transistor of the lower arm.

In some embodiments, the method further includes a feedforward equalizer (FFE) driver including an MSB amplifier and an LSB amplifier.

In some embodiments: the LSB amplifier of the FFE driver includes an upper arm and a lower arm, and the strength of the upper arm and the strength of the lower arm of the LSB amplifier of the FFE driver are independently adjustable.

In some embodiments: the MSB amplifier includes an upper arm and a lower arm, and the strength of the upper arm of the MSB amplifier or the strength of the lower arm of the MSB amplifier is adjustable.

According to an embodiment of the present disclosure, there is provided a method, including: receiving, by a receiver, from a transmitter connected to the receiver, a pulse amplitude modulation signal; generating, based on the signal, a measure of distortion; and sending, to the transmitter, an indication, the indication being based on the measure of distortion.

In some embodiments, the generating of the measure of distortion includes generating a Shmoo array.

### BRIEF DESCRIPTION OF THE DRAWINGS

These and other features and advantages of the present disclosure will be appreciated and understood with reference to the specification, claims, and appended drawings wherein:
FIG. 1A is a block diagram of a system including a plurality of interconnected digital circuits, according to an embodiment of the present disclosure;
FIG. 1B is a block diagram of two interconnected digital circuits, according to an embodiment of the present disclosure;
FIG. 1C is a block diagram of a transmitter and a receiver, according to an embodiment of the present disclosure;
FIG. 2 is an eye diagram, according to an embodiment of the present disclosure;
FIG. 3A is a circuit diagram of a pulse amplitude modulation 4-level (PAM4) driver circuit, according to an embodiment of the present disclosure;
FIG. 3B is a circuit diagram of an amplifier, according to an embodiment of the present disclosure;
FIG. 3C is a circuit of an amplifier including strength-adjusting transistors, according to an embodiment of the present disclosure;
FIG. 4 is a Shmoo diagram, according to an embodiment of the present disclosure;
FIG. 5A is a flowchart of a method for transmitting PAM4 data, according to an embodiment of the present disclosure; and
FIG. 5B is a flowchart of a method for transmitting PAM4 data, according to an embodiment of the present disclosure.

### DETAILED DESCRIPTION

The detailed description set forth below in connection with the appended drawings is intended as a description of aspects of some embodiments of a system and method for distortion mitigation in a data link provided in accordance with the present disclosure and is not intended to represent the only forms in which the present disclosure may be constructed or utilized. The description sets forth the features of the present disclosure in connection with the illustrated embodiments. It is to be understood, however, that the same or equivalent functions and structures may be accomplished by different embodiments that are also intended to be encompassed within the scope of the disclosure. As denoted elsewhere herein, like element numbers are intended to indicate like elements or features.

In various electronic and computer systems, it may be desirable to enable components in the system, such as graphics cards, hard drives (including, for example, solid state drives (SSDs), memory devices, network components or adaptors, or other peripheral components or devices, to communicate with each other using high-speed data transmission links. Such high-speed data links may include, for example, Universal Chiplet Interconnect Express (UCle), Peripheral Component Interconnect Express (PCIe), Knights Landing Token Interface (KTI), Ultra Path Interconnect (UPI), QuickPath Interconnect (QPI), Universal Serial Bus (USB) and the like. Such data links may enable relatively high data transmission speeds, flexibility in bandwidth allocation, simultaneous data transmission, relatively low latency, among other characteristics.

In a data link, data may be transmitted from a transmitter component or circuit (hereinafter referred to as a "transmitter") to a receiver component or circuit (hereinafter referred to as a "receiver") along with a clock signal. The clock signal, which may include two complementary signals, may be produced by two phase interpolators in the transmitter. In some systems the bitstream may carry an embedded clock. In some embodiments, the clock is transmitted separately, as a forwarded clock.

In such data links, pulse amplitude modulation 4-level (PAM4) may be used to increase the throughput at a given clock frequency. PAM4 may suffer from degraded performance, however, if distortion (e.g., in the transmitter, in the channel, or in the receiver) alters the received waveform, and, e.g., causes the waveform to exhibit an eye pattern in which one or more of the eyes are smaller than in a properly functioning link.

Such distortion may be mitigated, in some embodiments, using predistortion in the transmitter. For example, if the received signal has an upper eye that is smaller than normal, and the other two eyes (the middle eye and the lower eye) are larger than normal, then the transmitter may apply predistortion that enlarges the upper eye (and reduces the size of the other two eyes), so that when the signal is subsequently distorted (e.g., in the transmitter, in the channel, or in the receiver) the upper eye returns to (e.g., is reduced, by the distortion, to) normal size (as are the other two eyes). In some embodiments, the receiver characterizes the distortion and provides, to the transmitter, an indication of the characteristics of the distortion or an indication of how to apply predistortion suitable for mitigating the distortion manifested at the receiver.

The transmitter may apply predistortion using a driver including a most significant bit amplifier and a least significant bit amplifier, one or both of which is configurable to apply predistortion. For example, the least significant bit amplifier may include two switching transistors in an inverter configuration, and, in series with each of the switching transistors, a respective strength-adjusting transistor which limits the current that will flow through the switching transistor when the switching transistor is turned on. Each of the strength-adjusting transistors may be controlled by a strength control signal generated by the transmitter based on to the indication received from the receiver. Adjusting the strength-adjusting transistors may cause the levels of the PAM4 eye diagram to shift, causing changes in the sizes of the eyes. As mentioned above, such changes may be used as predistortion that may mitigate additional changes in the sizes of the eyes, which may result from subsequent distortion the signal may be subjected to.

The receiver may use a Shmoo array to assess the characteristics of the distortion of the received signal. The Shmoo array may be used to estimate the eye sizes; based on such estimates, the transmitter may apply suitable predistortion. Because the distortion is measured at the receiver, the applied predistortion may mitigate all of the distortion in the channel, including distortion occurring in the transmitter, in the channel, and in the receiver.

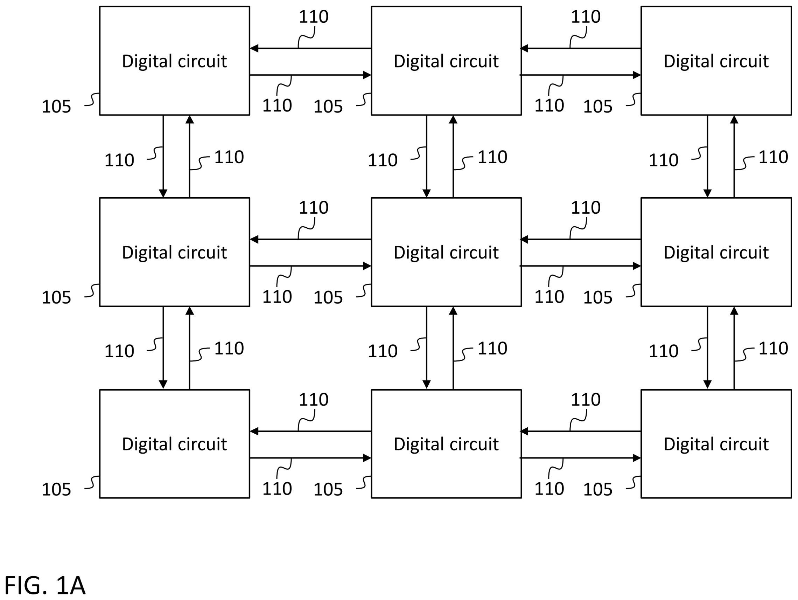

FIG. 1A shows a system-level diagram of a system including a plurality of digital circuits 105. Each of these circuits may be a single semiconductor chip (e.g., a silicon digital integrated circuit) such as a tensor flow processing unit (TPU), a central processing unit (CPU), a graphics processing unit (GPU), or a special purpose integrated circuit (e.g., a silicon application-specific integrated circuit (ASIC)), a hard drive (e.g., a solid state drive (SSD)), a memory device, a network component or adaptor, or other peripheral component or device. The digital circuits 105 may be connected by a plurality of data links 110, each of which may be a data link utilizing a data link protocol or mechanism. Such data links may make it possible, for example, for the digital circuits 105 to send data (e.g., data to be processed, or data that has been processed by one or more of the digital circuits 105) to each other. For example, a first digital circuit 105 may process data it receives (e.g., from off-chip or on-chip memory) and send the result to a second digital circuit 105. Communications between the plurality of digital circuits 105 and other circuits (e.g., memory circuits for storing data to be processed) may be performed over additional data links (not shown).

In some embodiments, each of the data links 110 is a Universal Chiplet Interconnect Express (UCle) data link, although embodiments according to the present disclosure are not limited thereto, and according to various embodiments, the data links 110 may utilize other data link protocols or mechanisms. A Universal Chiplet Interconnect Express (UCle) data link may be a data link that complies with an open industry standard (the UCle standard) designed to facilitate die-to-die interconnects and communication between dies (or "chiplets") in a multi-chip module (e.g., in a multi-chip system on a chip (SoC)). UCle may be used as a universal interconnect at the package level (e.g., within the package of a multi-chip module (e.g., a multi-chip SoC)).

The UCle standard specifies a standardized die-to-die interconnect that includes the physical layer, protocol stack, software model, and compliance testing procedures. The standardization allows components produced by different manufacturers to be inter-compatible. The physical layer of UCle supports relatively fast data transfer rates (e.g., up to 32 giga bits per second (Gbps)) over multiple lanes (e.g., between 16 and 64 lanes). Like a peripheral component interconnect express (PCIe) 6.0 link, a UCle link may use a 256-byte Flow Control Unit (FLIT) for data transmission. The physical specifications of the UCle standard are based on the Advanced Interface Bus (AIB) specifications; these physical specifications may result in high performance and power efficiency.

The UCle protocol layer is based on the Compute Express Link (CXL) standard and includes the CXL.io (PCIe), CXL.mem, and CXL.cache protocols. A data link complying with UCle may be compatible with various interconnect technologies, including organic substrates for standard 2D packages and embedded silicon bridges (e.g., embedded multi-die interconnect bridges EMIBs), silicon interposers, and fanout embedded bridges. Such interconnect technologies may enhance bandwidth density and power efficiency. A data link complying with UCle may exhibit significantly higher I/O performance and lower power consumption than, for example, a PCIe serializer/deserializer (SerDes). For example, a data link complying with UCle may provide bandwidth density up to 1.35 TB/s per mm² for a bump pitch of 45 µm.

Data links complying with UCle may be used in various applications, including high-performance computing data centers, edge computing, and automotive and high-reliability applications. Data links complying with UCle may be suitable for high-performance computing applications, in which efficient interconnects between dies may be important. In a data center, the use of data links complying with UCle may make possible the integration of diverse dies, allowing for customized solutions.

Artificial intelligence and machine learning applications may benefit from the high bandwidth and low latency that data links complying with UCle may exhibit. By enabling efficient data transfer between dies, data links complying with UCle may make possible the rapid processing and analysis of large datasets. In edge computing, data links complying with UCle may provide a portion of the infrastructure for deploying and managing dies at the edge of a network.

In automotive and high-reliability applications, data links complying with UCle may provide runtime health monitoring and repair features (which are part of the UCle specification). These features may ensure the robustness and reliability of the data links, allowing them to be suitable for safety-critical systems. Data links complying with UCle are compatible with three-dimensional (3D) packaging, with which high packaging densities may be achieved.

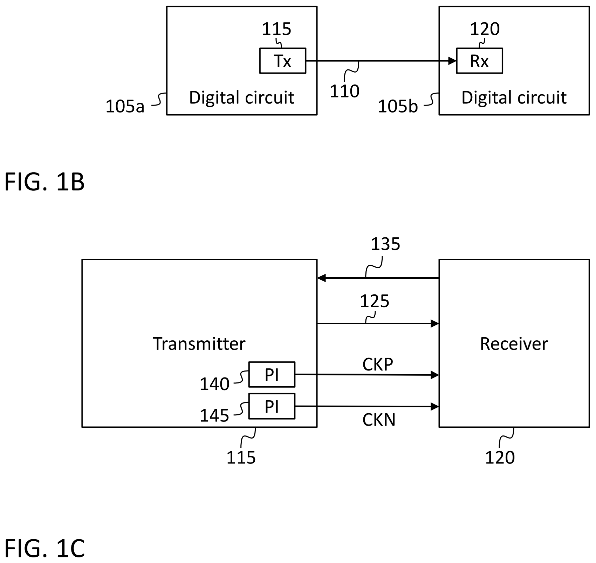

FIG. 1B shows a data link 110 between a first digital circuit 105a and a second digital circuit 105b, from among the digital circuits 105. The first digital circuit 105a includes a transmitter (Tx) (e.g., a UCle transmitter) 115 and the second digital circuit 105b includes a receiver (Rx) (e.g., a UCle receiver) 120. Although FIG. 1B illustrates the first digital circuit 105a including a transmitter 115 and the second digital circuit 105b including a receiver 120 for convenience of illustration and description, in various embodiments, each of the digital circuits may include both a transmitter and a receiver or a transceiver. The transmitter 115 may operate, for example, to convert or encode digital data from the first digital circuit 105a into a bitstream and transmit the bitstream over the physical medium (e.g., conductive wiring, optical fiber, and the like) of the data link 110 to the receiver 120 of the second digital circuit 105b.

FIG. 1C shows connections between the transmitter 115 and the receiver 120. The data link 110 may include a data channel 125 and a clock channel, each of which may include a pair of conductors forming a transmission line for transmitting complementary (e.g., differential) signals. The widths of the conductors, and the separation between the conductors of each pair of conductors may be selected to provide a characteristic impedance specified by the UCle standard, and both (i) the data and clock outputs of the transmitter 115 and (ii) the data and clock inputs of the receiver 120 may be impedance-matched to the characteristic impedance of the transmission line. As shown in FIG. 1C, the two differential signals (CKP and CKN) of the clock signal may be generated by a first phase interpolator (PI) 140 and a second phase interpolator 145. A sideband channel 135 may be used to send feedback or control signals (such as an indication related to distortion in the signal received by the receiver 120) from the receiver 120 to the transmitter 115.

In a data link, a high data rate may be advantageous to reduce the number of lanes required to carry a given throughput. Higher data rates may be achieved by using higher clock rates. Loss may be an obstacle, however; for example, for 64 gigabits per second (Gb/s) nonreturn to zero (NRZ), the maximum clock and data frequency may be 32 gigahertz (GHz). The loss at 32 GHz may be significant, making data recovery challenging. In some embodiments, therefore, pulse amplitude modulation 4-level (PAM4) signaling may be used to increase the throughput of a link, or to reduce the clock rate (e.g., to reduce the clock rate by a factor of 2, compared to an NRZ link with the same throughput).

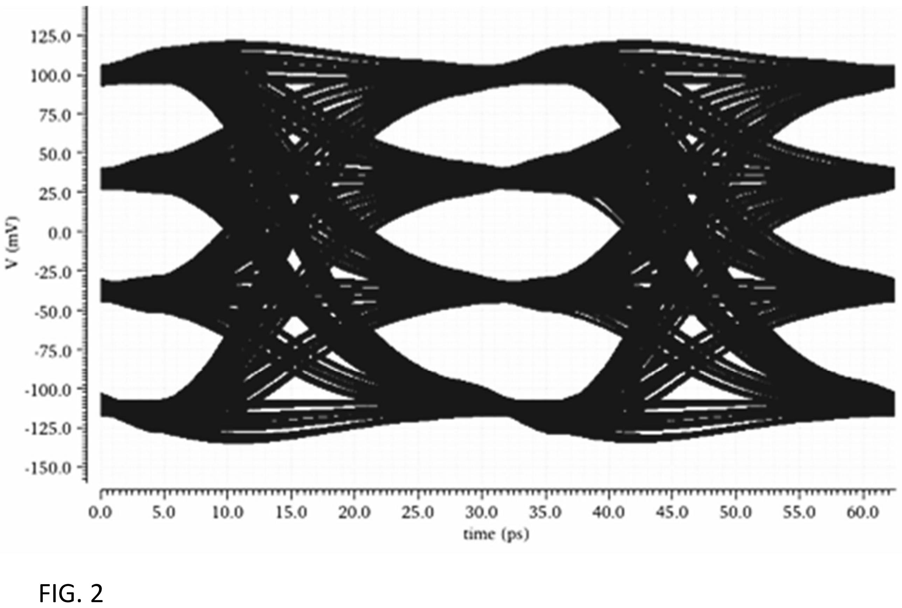

In a PAM4 link the linearity of the transmitter and of the receiver may be imperfect and the nonlinearity of these elements may limit or degrade the performance of the link. Nonlinearity may cause unequal data eye widths and heights and may limit the maximum achievable data rate. FIG. 2 shows an example of an eye diagram at a receiver in a PAM4 link, in the presence of distortion. It may be seen that the upper eye has a smaller height than the middle eye or the lower eye. This reduced size of the upper eye may increase the error rate of the link.

In some embodiments, the eye diagram of the waveform received by the receiver (e.g., the size of the upper eye) is improved by applying predistortion to the signal transmitted by the transmitter 115, as discussed in further detail below. Such predistortion applied at the transmitter 115 may counteract distortion to which the waveform is subjected after it is transmitted, resulting in a superior eye diagram for the received waveform. For example, if the upper eye is smaller than the middle eye and the lower eye, then the predistortion applied at the transmitter may result in an eye diagram, for the transmitted waveform, in which the upper eye is larger than the middle eye and the lower eye, so that in the eye diagram for the received waveform, all three eyes have approximately the same size.

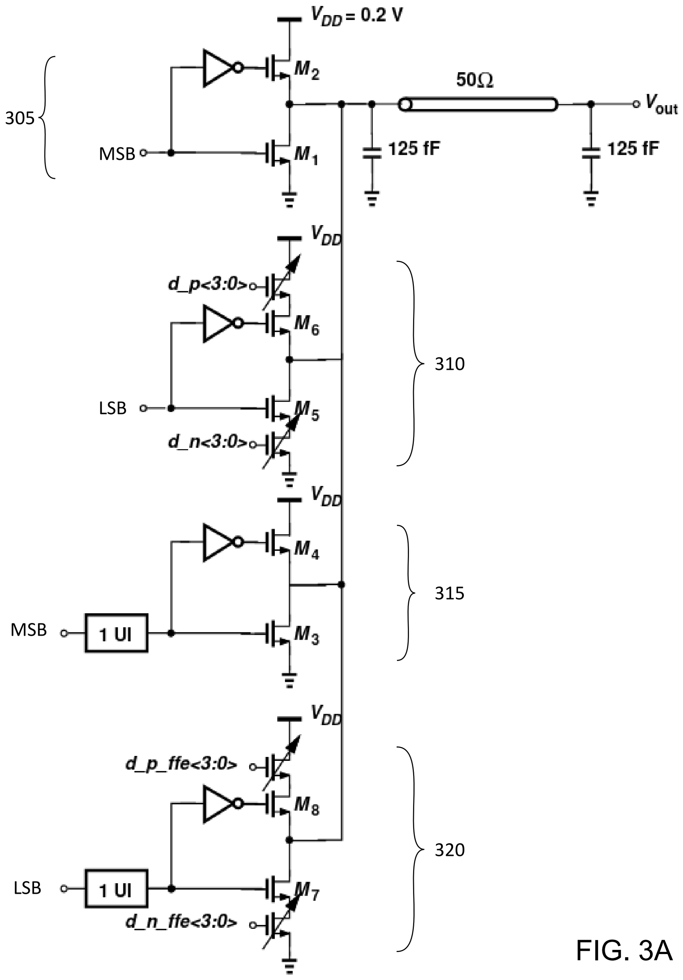

To apply predistortion to the transmitted waveform, a circuit like that of FIG. 3A may be used. The circuit of FIG. 3A includes a main driver including a most significant bit (MSB) amplifier 305 and a least significant bit (LSB) amplifier 310, and a feedforward equalizer (FFE) driver including an MSB amplifier 315 and an LSB amplifier 320. The feedforward equalizer amplifiers 315, 320 may each be driven with the two bits (most significant bit and the least significant bit) of the most recently transmitted symbol. This retransmission (e.g., with reduced amplitude) of the most recently transmitted symbol may suppress inter-symbol interference.

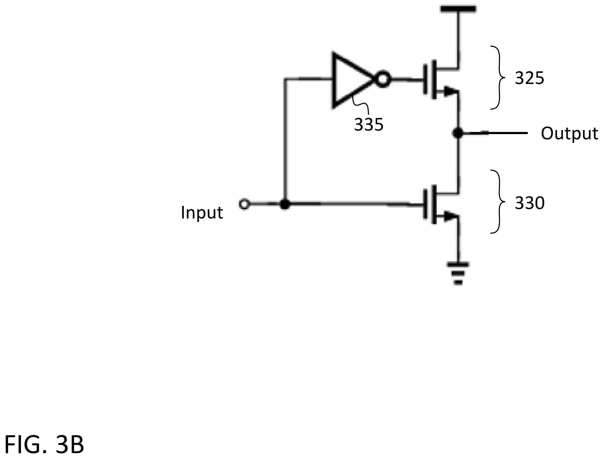

Each of the MSB amplifiers 305, 315 shown in FIG. 3A is an inverter. FIG. 3B shows a circuit diagram of such an inverter, which has an upper arm 325 and a lower arm 330 each including a respective transistor driven by the input. The transistors of the upper arm 325 and a lower arm 330 may be referred to as switching transistors because in operation, each may be either switched on or switched off. The amplifier of FIG. 3B is illustrated as including two n-channel metal oxide semiconductor (NMOS) transistors, with the transistor of the upper arm 325 being driven by an inverter 335. In some embodiments, the transistor of the upper arm 325 is instead a p-channel metal oxide semiconductor (PMOS) transistor, and no inverter is present.

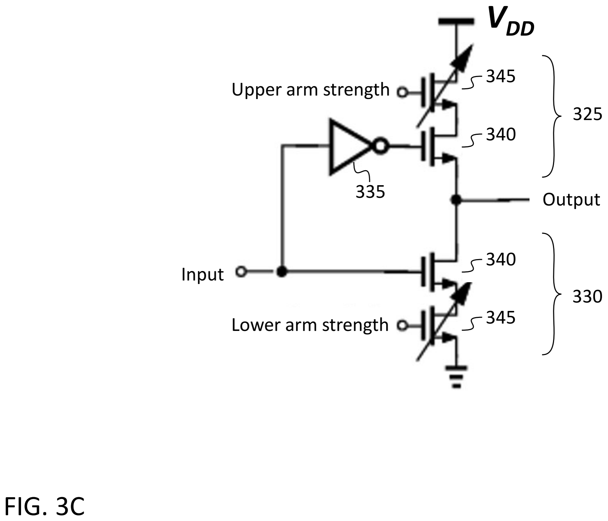

FIG. 3C shows a circuit diagram of a least significant bit amplifier (e.g., the least significant bit amplifier 310 of the main driver or the least significant bit amplifier 320 of the feedforward driver, which may be constructed using the same circuit). The amplifier includes two switching transistors 340 (one in the upper arm 325 and one in the lower arm 330) and two strength-adjusting transistors 345 (one in the upper arm 325 and one in the lower arm 330). Each of the strength-adjusting transistors 345 may be (independently) controlled by a respective strength control signal (an upper arm strength control signal applied to the gate of the strength-adjusting transistor 345 of the upper arm 325, and a lower arm strength control signal applied to the gate of the strength-adjusting transistor 345 of the lower arm 330). The strength-adjusting transistors 345 may operate as current-limiting devices, each limiting the current flowing through a respective switching transistor 340 (e.g., limiting the current flowing through the switching transistor 340 that is in the same arm as the strength-adjusting transistor 345).

The strength-adjusting transistors 345 of the least significant bit amplifier 310 of the main driver may be adjusted to apply predistortion to the transmitted signal as follows. Referring to the four levels produced by the PAM4 transmitter as levels 0, 1, 2, and 3 (with level 0 being ground, level 3 being VDD, and the two remaining levels being between levels 0 and 3 with level 2 being higher than level 1), it may be seen that the strength-adjusting transistors 345 of the least significant bit amplifier 310 of the main driver have little or no effect on levels 0 and 3 which are ground and VDD, respectively, because when the output is at level 0 or level 3, both the most significant bit amplifier 305 of the main driver and the least significant bit amplifier 310 of the main driver provide a connection to ground (when the output is at level 0) or to VDD (when the output is at level 3).

The voltage output for level 1, for which the most significant bit is low and the least significant bit is high, is determined by both (i) the strength of the lower arm 330 of the most significant bit amplifier 305 of the main driver, which sinks a first current to ground, and (ii) the strength of the upper arm 325 of the least significant bit amplifier 310 of the main driver, which sources a second current, smaller than the first current, from VDD. The remainder of the first current is drawn from the output, such that a corresponding voltage (e.g., a voltage approximately equal to the product of (i) the remainder of the current and (ii) the characteristic impedance of the transmission line to which the transmitter is connected) appears at the output of the PAM4 driver circuit. As such, increasing the strength of the upper arm 325 of the least significant bit amplifier 310 of the main driver may tend to increase level 1, and decreasing the strength of the upper arm 325 of the least significant bit amplifier 310 of the main driver may tend to decrease level 1. The strength of the upper arm 325 of the least significant bit amplifier 310 of the main driver may be adjusted by adjusting the upper arm strength control signal applied to the gate of the strength-adjusting transistor of the upper arm 325 of the least significant bit amplifier 310 of the main driver, so as (i) to increase the current flowing through this transistor (to increase the upper arm strength) or (ii) to decrease the current flowing through this transistor (to decrease the upper arm strength).

In an analogous manner, the voltage output for level 2, for which the most significant bit is high and the least significant bit is low, is determined by both (i) the strength of the upper arm 330 of the most significant bit amplifier 305 of the main driver, which sources a first current from VDD, and (ii) the strength of the lower arm 330 of the least significant bit amplifier 310 of the main driver, which sinks a second current, smaller than the first current, to ground. The remainder of the first current flows into the output, generating a corresponding voltage at the output of the PAM4 driver circuit. Increasing the strength of the lower arm 330 of the least significant bit amplifier 310 of the main driver may therefore tend to decrease level 2, and decreasing the strength of the lower arm 330 of the least significant bit amplifier 310 of the main driver may tend to increase level 2. As such, adjustments to the upper arm and lower arm strength control signals applied to the least significant bit amplifier 310 of the main driver may be used to adjust level 1 and level 2, thereby achieving predistortion that produces any desired combination of the sizes of the three eyes.

In some embodiments, the strength-adjusting transistors 345 of the least significant bit amplifier 320 of the feedforward driver may be adjusted in the same manner, so that levels to which predistortion has been applied are transmitted (at reduced amplitude) in the following symbol, so as to provide more effective cancellation of inter-symbol interference than would be provided by transmitting previously transmitted symbols without predistortion.

In some embodiments, the strengths of both the most significant bit amplifier 315 of the feedforward driver and the least significant bit amplifier 320 of the feedforward driver are less than the respective strengths of the most significant bit amplifier 305 of the main driver and the least significant bit amplifier 310 of the main driver, in a ratio corresponding to the amount of inter-symbol interference imposed by the channel. This may be accomplished by fabricating the switching transistors of the most significant bit amplifier 315 of the feedforward driver to have narrower channels than the transistors of the most significant bit amplifier 305 of the main driver, and by controlling the strength-adjusting transistors 345 of the least significant bit amplifier 320 of the feedforward driver to provide reduced strength to both arms (in addition to any strength adjustments made for the application of predistortion).

In some embodiments, the most significant bit amplifier 315 of the feedforward driver is an amplifier according to FIG. 3C, and the strength-adjusting transistors 345 of the most significant bit amplifier 315 of the feedforward driver are used to adjust the magnitude of the feedforward equalization modulation. In such an embodiment, the common-mode or average strengths of all of the strength-adjusting transistors 345 of the feedforward equalization driver may be adjusted during operation, e.g., using a least mean squares controller that may detect and minimize inter-symbol interference.

In some embodiments, the most significant bit amplifier 305 of the main driver is an amplifier according to FIG. 3C, and the strength-adjusting transistors 345 of the most significant bit amplifier 305 of the main driver are used to apply predistortion in addition to, or instead of, predistortion being applied by the strength-adjusting transistors 345 of the least significant bit amplifier 310 of the main driver. If the least significant bit amplifier 310 of the main driver is not used to apply predistortion, then it may be an amplifier according to FIG. 3B.

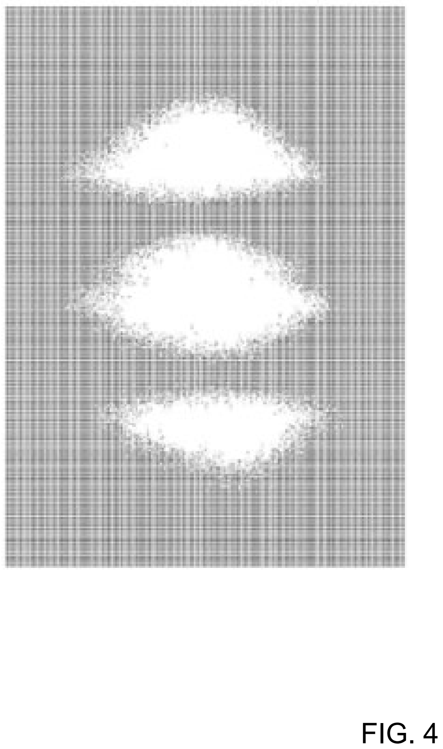

In some embodiments, the receiver 120 detects distortion in the received waveform and sends, to the transmitter 115, indications based on the detected distortion. The transmitter may then adjust the strength-adjusting transistors 345 so as to reduce the distortion. For example, the receiver may include three clocked comparators, one for each eye of the PAM4 waveform. During normal operation, each comparator may have a threshold approximately centered in a respective eye of the waveform, and the slicing clock may be approximately synchronized with the point at which each eye is tallest. To generate a Shmoo array (which is an array of digital values (0 or 1) in a rectangular array having time along the horizontal axis and voltage along the vertical axis), the receiver may sweep a slicing clock time offset, and for each slicing clock time offset, sweep each of the reference voltages up and down. During these sweeps, the receiver may store a zero in the array element corresponding to the current time and voltage coordinate if the error rate exceeds a threshold, and a one if the error rate is below the threshold. FIG. 4 shows an example of a Shmoo diagram, which a graphical representation of a Shmoo array, in which each zero is represented by a gray dot and each one is represented by a white dot. In the Shmoo diagram of FIG. 4, the lower white region is smaller than the other two white regions, from which it may be inferred that in the received waveform the lower eye is smaller than the other two eyes (as a result of which, for example, the amount by which the lower threshold voltage can be changed without incurring unacceptable errors is smaller).

As, such the indication that the receiver may send to the transmitter may be the Shmoo array (from which the transmitter may infer which eye or eyes to enlarge and which eye or eyes to make smaller) or the indication may be a measure (e.g., the height or the width) of each eye, or an instruction to increase or decrease the strength control signal of one of the strength-adjusting transistors 345. A system and method as described herein, in which the distortion measured by the receiver is used to adjust the predistortion applied by the transmitter may have the advantage of (at least partially) cancelling (i) distortion caused by nonlinearity in the transmitter 115, (ii) any nonlinearity in the channel between the transmitter 115 and the receiver 120, and (iii) distortion caused by nonlinearity in the receiver 120.

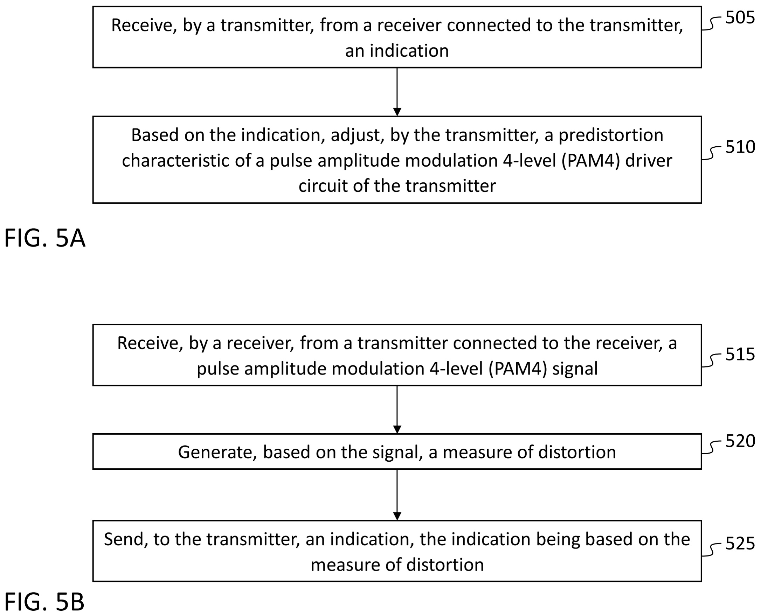

FIG. 5A shows a method for transmitting PAM4 data, in some embodiments. Although FIG. 5A illustrates various operations in such a method, embodiments according to the present disclosure are not limited thereto. For example, according to some embodiments, such a method may include additional operations or fewer operations, or the order of operations may vary (unless otherwise explicitly stated or implied) without departing from the spirit and scope of embodiments according to the present disclosure.

The method of FIG. 5A includes receiving, at 505, by a transmitter, from a receiver connected to the transmitter, an indication; and, based on the indication, adjusting, at 510, by the transmitter, a predistortion characteristic of a pulse amplitude modulation 4-level (PAM4) driver circuit of the transmitter. For example, as discussed above, the receiver may send, to the transmitter, a Shmoo array, or an instruction to adjust the strength control signal of a strength-adjusting transistors 345, and, in response, the transmitter may adjust the strength control signal of a strength-adjusting transistors 345, thereby adjusting a predistortion characteristic of a pulse amplitude modulation 4-level (PAM4) driver circuit of the transmitter.

FIG. 5B shows a method for transmitting PAM4 data, in some embodiments. Although FIG. 5B illustrates various operations in such a method, embodiments according to the present disclosure are not limited thereto. For example, according to some embodiments, such a method may include additional operations or fewer operations, or the order of operations may vary (unless otherwise explicitly stated or implied) without departing from the spirit and scope of embodiments according to the present disclosure.

The method of FIG. 5B includes receiving, at 515, by a receiver, from a transmitter connected to the receiver, a pulse amplitude modulation 4-level (PAM4) signal, and generating, at 520, based on the signal, a measure of distortion. For example, as discussed above, the receiver may receive a signal from the transmitter, generate a Shmoo array, and infer from the Shmoo array that one eye of the eye diagram is smaller than the other two eyes. The method further includes sending, at 525, to the transmitter, an indication, the indication being based on the measure of distortion.

Although some examples herein are described in the context of PAM4 modulation, the present disclosure is not limited to such embodiments, and, for example, an analogous system and method may be used to mitigate distortion in pulse amplitude modulation 8-level or pulse amplitude modulation 16-level systems.

As used herein, "a portion of" something means "at least some of" the thing, and as such may mean less than all of, or all of, the thing. As such, "a portion of" a thing includes the entire thing as a special case, i.e., the entire thing is an example of a portion of the thing. As used herein, when a second quantity is "within Y" of a first quantity X, it means that the second quantity is at least X-Y and the second quantity is at most X+Y. As used herein, when a second number is "within Y%" of a first number, it means that the second number is at least (1-Y/100) times the first number and the second number is at most (1+Y/100) times the first number. As used herein, the term "or" should be interpreted as "and/or", such that, for example, "A or B" means any one of "A" or "B" or "A and B".

The background provided in the Background section of the present disclosure section is included only to set context, and the content of this section is not admitted to be prior art. Any of the components or any combination of the components described (e.g., in any system diagrams included herein) may be used to perform one or more of the operations of any flow chart included herein. Further, (i) the operations are example operations, and may involve various additional steps not explicitly covered, and (ii) the temporal order of the operations may be varied.

Each of the terms "processing circuit" and "means for processing" is used herein to mean any combination of hardware, firmware, and software, employed to process data or digital signals. Processing circuit hardware may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processing circuit, as used herein, each function is performed either by hardware configured, i.e., hardwired, to perform that function, or by more general-purpose hardware, such as a CPU, configured to execute instructions stored in a non-transitory storage medium. A processing circuit may be fabricated on a single printed circuit board (PCB) or distributed over several interconnected PCBs. A processing circuit may contain other processing circuits; for example, a processing circuit may include two processing circuits, an FPGA and a CPU, interconnected on a PCB.

As used herein, the term "array" refers to an ordered set of numbers regardless of how stored (e.g., whether stored in consecutive memory locations, or in a linked list).

As used herein, when a method (e.g., an adjustment) or a first quantity (e.g., a first variable) is referred to as being "based on" a second quantity (e.g., a second variable) it means that the second quantity is an input to the method or influences the first quantity, e.g., the second quantity may be an input (e.g., the only input, or one of several inputs) to a function that calculates the first quantity, or the first quantity may be equal to the second quantity, or the first quantity may be the same as (e.g., stored at the same location or locations in memory as) the second quantity.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the spirit and scope of the inventive concept.

The terminology used herein is for the purpose of describing particular embodiments only and is not intended to be limiting of the inventive concept. As used herein, the terms "substantially," "about," and similar terms are used as terms of approximation and not as terms of degree, and are intended to account for the inherent deviations in measured or calculated values that would be recognized by those of ordinary skill in the art.

As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" or "between 1.0 and 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Similarly, a range described as "within 35% of 10" is intended to include all subranges between (and including) the recited minimum value of 6.5 (i.e., (1 - 35/100) times 10) and the recited maximum value of 13.5 (i.e., (1 + 35/100) times 10), that is, having a minimum value equal to or greater than 6.5 and a maximum value equal to or less than 13.5, such as, for example, 7.4 to 10.6. Any maximum numerical limitation recited herein is intended to include all lower numerical limitations subsumed therein and any minimum numerical limitation recited in this specification is intended to include all higher numerical limitations subsumed therein.

It will be understood that when an element is referred to as being "directly connected" or "directly coupled" to another element, there are no intervening elements present. As used herein, "generally connected" means connected by an electrical path that may contain arbitrary intervening elements, including intervening elements the presence of which qualitatively changes the behavior of the circuit. As used herein, "connected" means (i) "directly connected" or (ii) connected with intervening elements, the intervening elements being ones (e.g., low-value resistors or inductors, or short sections of transmission line) that do not qualitatively affect the behavior of the circuit.

Some embodiments may include features of the following numbered statements.
1. A system, comprising:
   a transmitter, comprising:
      a pulse amplitude modulation driver circuit, comprising:
      a main driver comprising a most significant bit (MSB) amplifier and a least significant bit (LSB) amplifier,
   the LSB amplifier comprising an upper arm and a lower arm, a strength of the upper arm or a strength of the lower arm being adjustable.
2. The system of statement 1, wherein the strength of the upper arm is adjustable, and the upper arm comprises:
   a switching transistor; and
   a strength-adjusting transistor, connected in series with the switching transistor.
3. The system of statement 1 or statement 2, wherein:
   the strength of the lower arm is adjustable independently of the strength of the upper arm, and
   the lower arm comprises:
      a switching transistor and
      a strength-adjusting transistor, connected in series with the switching transistor of the lower arm.
4. The system of any one of the preceding statements, further comprising a feedforward equalizer (FFE) driver comprising an MSB amplifier and an LSB amplifier.
5. The system of statement 4, wherein:
   the LSB amplifier of the FFE driver comprises an upper arm and a lower arm, and
   a strength of the upper arm and a strength of the lower arm of the LSB amplifier of the FFE driver are independently adjustable.
6. The system of any one of the preceding statements, wherein:
   the MSB amplifier comprises an upper arm and a lower arm, and
   the strength of the upper arm of the MSB amplifier or the strength of the lower arm of the MSB amplifier is adjustable.
7. The system of any one of the preceding statements, wherein the transmitter is configured:
   to receive an indication from a receiver connected to the transmitter, and
   to adjust the strength of the upper arm or the strength of the lower arm based on the indication.
8. The system of statement 7, wherein the indication is an instruction to adjust the strength of the upper arm or the strength of the lower arm.
9. The system of statement 7, wherein the indication is an indication of an eye size.
10. The system of any one of statements 7 to 9, further comprising the receiver, wherein the receiver is configured to generate the indication based on a measure of distortion of a pulse amplitude modulation signal received from the transmitter.
11. The system of statement 10, wherein the measure of distortion is a Shmoo array.
12. A method, comprising:
   receiving, by a transmitter, from a receiver connected to the transmitter, an indication; and
   based on the indication, adjusting, by the transmitter, a predistortion characteristic of a pulse amplitude modulation driver circuit of the transmitter.
13. The method of statement 12, wherein:
   the pulse amplitude modulation driver circuit comprises a main driver comprising a most significant bit (MSB) amplifier and a least significant bit (LSB) amplifier; and
   the LSB amplifier comprises an upper arm and a lower arm, a strength of the upper arm or a strength of the lower arm being adjustable.
14. The method of statement 12 or statement 13, wherein the strength of the upper arm is adjustable, and the upper arm comprises:
   a switching transistor; and
   a strength-adjusting transistor, connected in series with the switching transistor.
15. The method of any one of statements 12 to 14, wherein:
   the strength of the lower arm is adjustable independently of the strength of the upper arm, and
   the lower arm comprises:
      a switching transistor and
      a strength-adjusting transistor, connected in series with the switching transistor of the lower arm.
16. The method of any one of statements 12 to 15, further comprising a feedforward equalizer (FFE) driver comprising an MSB amplifier and an LSB amplifier.
17. The method of statement 16, wherein:
   the LSB amplifier of the FFE driver comprises an upper arm and a lower arm, and
   the strength of the upper arm and the strength of the lower arm of the LSB amplifier of the FFE driver are independently adjustable.
18. The method of any one of statements 12 to 17, wherein:
   the MSB amplifier comprises an upper arm and a lower arm, and
   the strength of the upper arm of the MSB amplifier or the strength of the lower arm of the MSB amplifier is adjustable.
19. A method, comprising:
   receiving, by a receiver, from a transmitter connected to the receiver, a pulse amplitude modulation signal;
   generating, based on the signal, a measure of distortion; and
   sending, to the transmitter, an indication, the indication being based on the measure of distortion.
20. The method of statement 19, wherein the generating of the measure of distortion comprises generating a Shmoo array.

Although exemplary embodiments of a system and method for distortion mitigation in a data link have been specifically described and illustrated herein, many modifications and variations will be apparent to those skilled in the art. Accordingly, it is to be understood that a system and method for distortion mitigation in a data link constructed according to principles of this disclosure may be embodied other than as specifically described herein. The invention is also defined in the following claims.

## Claims

1. A system, comprising:
a transmitter (115), comprising:
a pulse amplitude modulation driver circuit, comprising:
a main driver comprising a first most significant bit, MSB, amplifier (305) and a first least significant bit, LSB, amplifier (310),
the first LSB amplifier (310) comprising a first upper arm (325) and a first lower arm (330), a strength of the first upper arm (325) and/or a strength of the first lower arm (330) being adjustable.

2. The system of claim 1, wherein the strength of the first upper arm (325) is adjustable, and the first upper arm (325) comprises:
a first switching transistor (340); and
a first strength-adjusting transistor (345), connected in series with the first switching transistor (340).

3. The system of claim 2, wherein:
the strength of the first lower arm (330) is adjustable independently of the strength of the first upper arm (325), and
the first lower arm (330) comprises:
a second switching transistor (340) and
a second strength-adjusting transistor (345), connected in series with the second switching transistor (340) of the first lower arm (330).

4. The system of any one of claims 1 to 3, further comprising a feedforward equalizer, FFE, driver comprising a second MSB amplifier (315) and a second LSB amplifier (320).

5. The system of claim 4, wherein:
the second LSB amplifier (320) of the FFE driver comprises a second upper arm (325) and a second lower arm (330), and
a strength of the second upper arm (325) and a strength of the second lower arm (330) of the LSB amplifier (320) of the FFE driver are independently adjustable.

6. The system of any one of claims 1 to 5, wherein:
the first MSB amplifier (305) comprises a third upper arm (325) and a third lower arm (330), and
the strength of the third upper arm (325) of the first MSB amplifier (305) and/or the strength of the third lower arm of the first MSB amplifier (305) is adjustable.

7. The system of any one of claims 1 to 6, wherein the transmitter (115) is configured:
to receive an indication from a receiver (120) connected to the transmitter (115), and
to adjust the strength of the first upper arm (325) or the strength of the first lower arm (330) based on the indication.

8. The system of claim 7, wherein the indication is an instruction to adjust the strength of the first upper arm (325) or the strength of the first lower arm (330).

9. The system of claim 7 or 8, wherein the indication is an indication of an eye size.

10. The system of any one of claims 7 to 9, further comprising the receiver (120), wherein the receiver (120) is configured to generate the indication based on a measure of distortion of a pulse amplitude modulation signal received from the transmitter (115).

11. The system of claim 10, wherein the measure of distortion is a Shmoo array.

12. A method, comprising:
receiving, by a transmitter (115), from a receiver (120) connected to the transmitter (115), an indication; and
based on the indication, adjusting, by the transmitter (115), a predistortion characteristic of a pulse amplitude modulation driver circuit of the transmitter (115).

13. The method of claim 12, wherein:
the pulse amplitude modulation driver circuit comprises a main driver comprising a most significant bit, MSB, amplifier (305) and a least significant bit, LSB, amplifier (310); and
the LSB amplifier (310) comprises an upper arm (325) and a lower arm (330), a strength of the upper arm (325) and/or a strength of the lower arm (330) being adjustable.

14. The method of claim 13, wherein the strength of the upper arm (325) is adjustable, and the upper arm (325) comprises:
a first switching transistor (340); and
a first strength-adjusting transistor (345), connected in series with the first switching transistor (340).

15. The method of claim 14, wherein:
the strength of the lower arm (330) is adjustable independently of the strength of the upper arm (325), and
the lower arm (330) comprises:
a second switching transistor (340) and
a strength-adjusting transistor (345), connected in series with the second switching transistor (340) of the lower arm (330).
